(19) **Europäisches Patentamt**

**European Patent Office**

**Office européen des brevets**

(11) **EP 0 902 434 B1**

(12) **EUROPEAN PATENT SPECIFICATION**

(45) Date of publication and mention
of the grant of the patent:
**06.05.2004 Bulletin 2004/19**

(51) Int Cl.7: **G11C 7/00**, G11C 11/409

(21) Application number: **98306761.2**

(22) Date of filing: **24.08.1998**

(54) **Hierarchical column select line architecture for multi-bank drams and method therefor**

Hierarchische Spaltenleitungsauswahl für Multi-Bank-DRAM-Speicher und Verfahren dazu

Architecture hiérarchique de ligne de sélection de colonne pour des mémoires DRAM multibancs et méthode pour telle

(84) Designated Contracting States:
**DE FR GB**

(30) Priority: **11.09.1997 US 927158**
**11.09.1997 US 927160**

(43) Date of publication of application:
**17.03.1999 Bulletin 1999/11**

(73) Proprietor: **International Business Machines
Corporation
Armonk, NY 10504 (US)**

(72) Inventor: **Kirihata, Toshiaki
Poughkeepsie, New York 12603 (US)**

(74) Representative: **Burt, Roger James, Dr. et al
IBM United Kingdom Limited
Intellectual Property Department
Hursley Park
Winchester Hampshire SO21 2JN (GB)**

(56) References cited:
**EP-A- 0 401 792        US-A- 5 361 223
US-A- 5 592 434**

**Description**

This invention relates generally to semiconductor memory devices, and more particularly, to a multi-bank dynamic random access memory having a hierarchical column select line architecture and to a method of structuring such a memory device.

CMOS technology has evolved such that the computer market has rapidly opened to a wide range of consumers. Today multi-media applications require at least an 8 MB and preferably even a 16 Mb memory, which increases the relative cost of the memory system within a computer. In the near future, it is likely that 32 MB and 64 MB computers will become commonplace, which suggests a potential demand for 256 Mb DRAMs (Dynamic Random Access Memory) and beyond. Still in the development stage, DRAMs in the Gigabit range are already under way.

DRAM architectures have evolved over the years driven by system requirements that necessitate larger memory capacity. The speed of a DRAM, characterised by its random access time (tRAC) and by its random access cycle time (tRC), however, has not improved in a like manner. This has created a large speed gap between the DRAMs and the CPU, particularly, since the speed of the clock of the CPU is consistently improving over time.

In order to overcome this problem, a cache is now commonly used, not only for high-end workstations, but also for multimedia computers. A cache. however, requires fast and expensive SRAMs, increasing system cost. Furthermore, even with this expensive and complex cache. the system performance, particularly with large density memories, cannot be significantly enhanced in view of the high probability of a cache miss. It is therefore crucial. if the DRAM speed (i.e., tRAC and tRC) is to approach that of an SRAM, that the cache overhead be reduced or, preferably, ultimately eliminated.

The tRAC and the tRC in a DRAM are fundamentally slower than in an SRAM. This is because the amount of data stored in DRAM cells is small when compared to that stored in an SRAM. Therefore, small signals, which are characteristic of DRAMs, need to be amplified which, in turn, slows down tRAC. Moreover, the data that is read in a DRAM is destroyed and must be restored in order to initiate the next read or write operation, thereby slowing the tRC.

A multi-bank DRAM containing several independently controllable arrays within a chip, allows starting a next operation using the pipeline approach. This method is ideal for boosting tRC. By way of example, having two banks in a chip allows halving tRC.

The tRAC of two consecutive random access operations are transparent to previous operations, since a next operation may start prior to a previous one being completed. It is because of these considerations that the concept of introducing multi-banks in a chip is of such importance for current and future systems. Such an architecture has already been used in several multi-bank DRAMs products. such as SDRAMs, RDRAMs, and MDRAMs. Designing multi-banks in a single chip, however, requires special handling when implementing this concept in a hierarchical Column Select Line (CSL) architecture. which is not found in a single-bank DRAM.

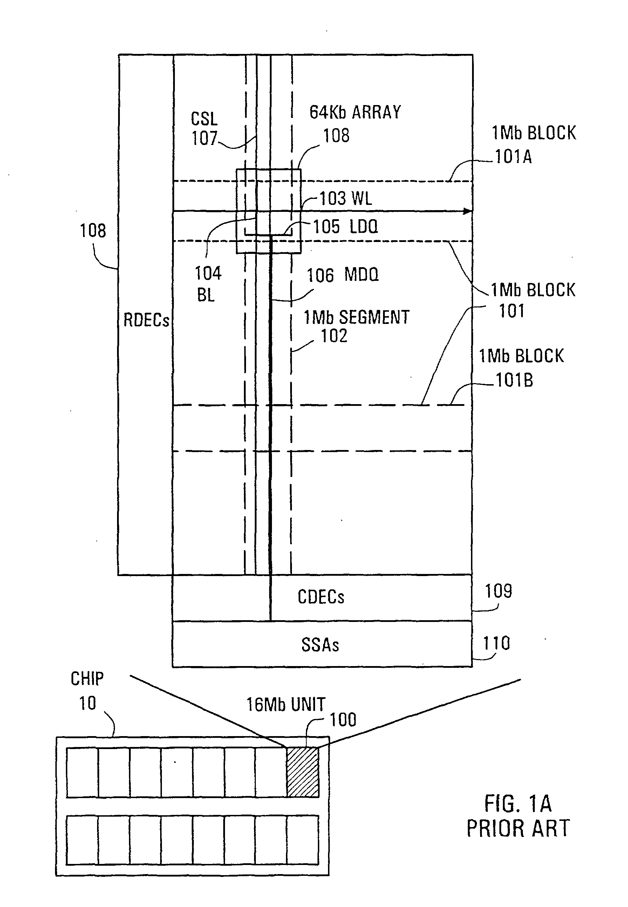

By way of example, and with reference to FIG. 1a, is depicted a Master-DQ (MDQ) architecture of a 256 Mb DRAM, allowing for a wide I/O organisation with a small silicon area overhead. This architecture is more fully described in an article entitled: "A 286mm2 256 Mb DRAM with x32 both-ends DQ", by Y. Watanabe et al., published in the IEEE Journal for Solid-State Circuits, Vol. 31, No. 4, pp. 567-574. This DRAM is configured as a "single bank" architecture, (a bank being defined as an array which can be independently controlled, and more specifically, wherein the next 'random access mode', in which the next wordline in a different bank needs to be activated, can be initiated before previous 'random access modes' have been completed).

Chip 10, shown in Fig. 1a, includes sixteen 16Mb units 100. each consisting of sixteen 1Mb blocks 101. Each 1Mb block 101 contains 512 wordlines (WLs) 103 spanning in a horizontal direction, and 2048 bitline pairs (BLs) 104 spanning in a vertical direction. For simplicity sake. Row Decoders (RDECs) 108 are located at the left of each 16Mb unit 100. The Column Decoders (CDECs) 109 and the second sense amplifiers (SSAs) 110 are placed at the bottom of each 16Mb unit 100. For column direction, the 16Mb unit 100 consists of sixteen 1Mb segments 102. The 32 column select lines CSLs 107 and the 4 hierarchical data lines having local-DQ (LDQ) 105 and 4 master-DQ (MDQ) 106 are arranged over each 1Mb segment 102. The intersection of 1Mb block 101 and 1Mb segment 102 contains 64Kb array 108. In summary, the 1Mb block 101 contains sixteen 64Kb arrays 108, while the 1Mb segment consists of sixteen 64Kb arrays 108.

For clarity and simplicity sake, the discussion following hereinafter assumes only one of the sixteen 1Mb block 101 to be active at any given time, the data of which is transferred with LDQ and NIDQ to the corresponding 1 Mb segment 102.

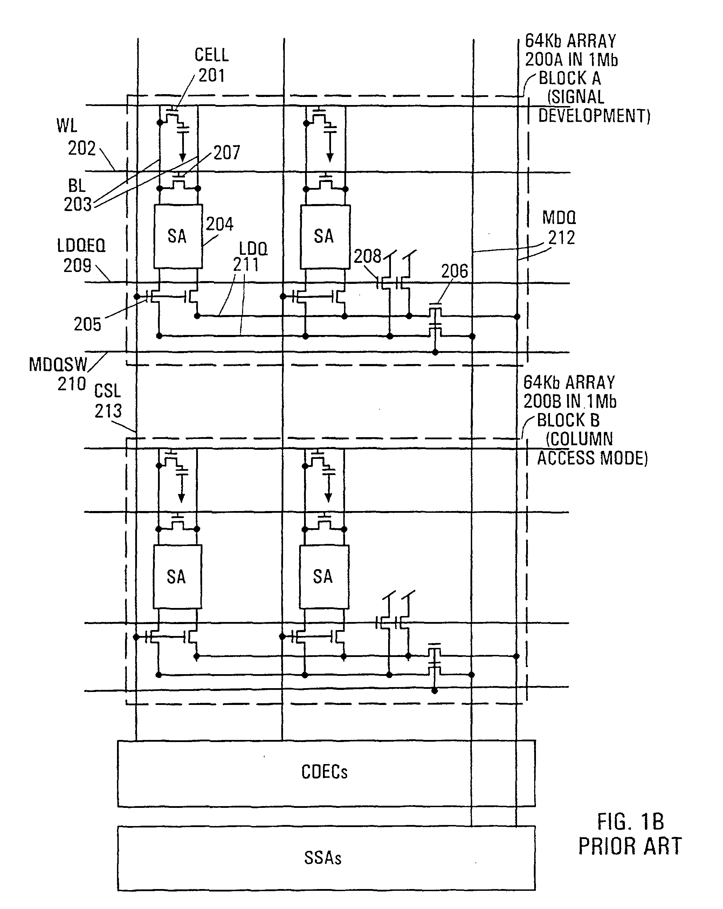

Fig. 1b shows a more detailed schematic of the 1Mb segment 102 depicted in Fig. 1a, wherein two sixteen 64Kb arravs 200A and 200B out of 16 are illustrated.

200A and 200B are, respectively, the intersection area between the block 101A and the segment 102, and the intersection area between the block 101 B and the segment 102 (Fig. 1a). The 64Kb array consists of 512 WLs 202 and 128 BL pairs 203. As discussed previously, 32 CSLs 213,4 LDQ pairs 211, and 4 MDQ pairs 212, are arranged over this 1Mb segment. (For simplicity sake. Fig. 1b is shown to include only 1 out of 4 of each of the features BLs, LDQs, and MDQs, comprising this arrangement.) When one of the 32 CSLs 213 are activated, 4 of the 128 BL pairs 203 are coupled to the corresponding 4 LDQ pairs 211 and 4 MDQ pairs 212. The detailed operation of a single bank DRAM and problems relating to a multi-bank DRAM are described next.

When in standby mode (i.e., when no WL 202 and no CSL 213 are active, resulting in no data being written in or read out of the memory), all BLs 203 and LDQs 211 are pre-charged to ½ the value of the power supply Vdd. MDQs 212 are precharged to the Vdd level. When a 1Mb block A is selected, BL equalisers 207 and MDQ equalisers 208 are disabled first. MDQ lines 212 are coupled to LDQ 211 through MDQ transistor 206. This allows LDQ 211 to be pre-charged to the value of Vdd. WL 202 then rises to read data from cell 201. Sense amplifiers (SA) 204 are activated only after the signal has been sufficiently developed (typically, 90%) on BLs 203.

CSL 213 rises to transfer data from selected BL 203 pair to the respective pairs. LDQ 211 and MDQ 212, for a read mode (or inversely, for a write mode). BLs and LDQs in an unselected 1Mb block B are kept at ½ Vdd's pre-charged level, since the BL and LDQ equalisers are 'on', while the NIDQ transistor 206 remains 'off'. This organisation allows CSLs 213 to be shared between the 1Mb blocks A and B. requiring only one column decoder for each 16Mb unit, preferably located at the bottom of each 16Mb unit.

The MDQ architecture suffers from a fundamental deficiency, in the instance when A and B 1Mb banks are operated as two separate entities. By way of example, if the 1Mb block A is in a 'signal development mode' (i.e., when data is read out of a memory cell and transferred to the bitline), the 1Mb block B may be in a'column access mode' (i.e., the time it takes to read or write data to a cell). Because the CSLs are shared between banks A and B, the column switch transistor 205 in array 200A, now in the signal development phase, is also activated, thereby destroying the data in cell 201 in array 200A. Column switch transistor 205 must remain in the off state during the signal development mode in order not to destroy the data.

The exact timing when the signal development phase starts and the timing when the column transistor phase opens cannot be internally predicted because they are externally controlled by the system designer and/or by customer constraints. To overcome this problem, three solutions, embodied in more advanced architectures, to be described hereinafter, have been advanced.

In a first solution (not shown in the drawings) described in an article published in the IEEE Journal of Solid-State Circuits, Vol. 31, No. 11, pp. 1656-1668, entitled: "A 2.5ns Clock Access, 250 MHz, 256 Mb SDRAM with Synchronous Mirror Delay", by T. Saeki, et al., four banks are configured having four units, each of which is controlled by its own independent column decoders. Since the CSLs are not shared among the various banks, the problem previously described is bypassed.

However, the number of banks configured in the chip is limited by the number of units present, which is not adequate for configurations of 16 or more banks, which are required for a 1Gb DRAM design.

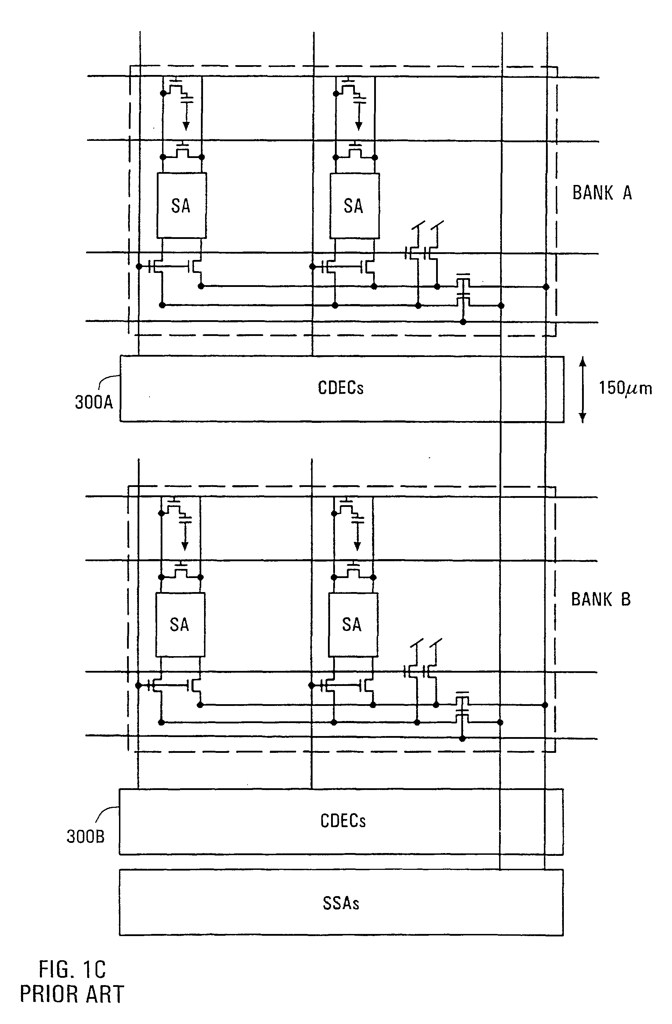

In a second solution, illustrated in FIG. 1c, two column decoders 300A and 300B are shown, respectively controlling banks A and B. More specifically, the CSLs in the corresponding bank are independently controlled by full column decoders 300A and 300B.

However, by duplicating the number of full column decoders, a substantial penalty in added chip real estate is imposed on the designer as. for instance, by increasing the height of the 16Mb unit by ~150lm for the two banks A and B (and 150lm for each additional bank).

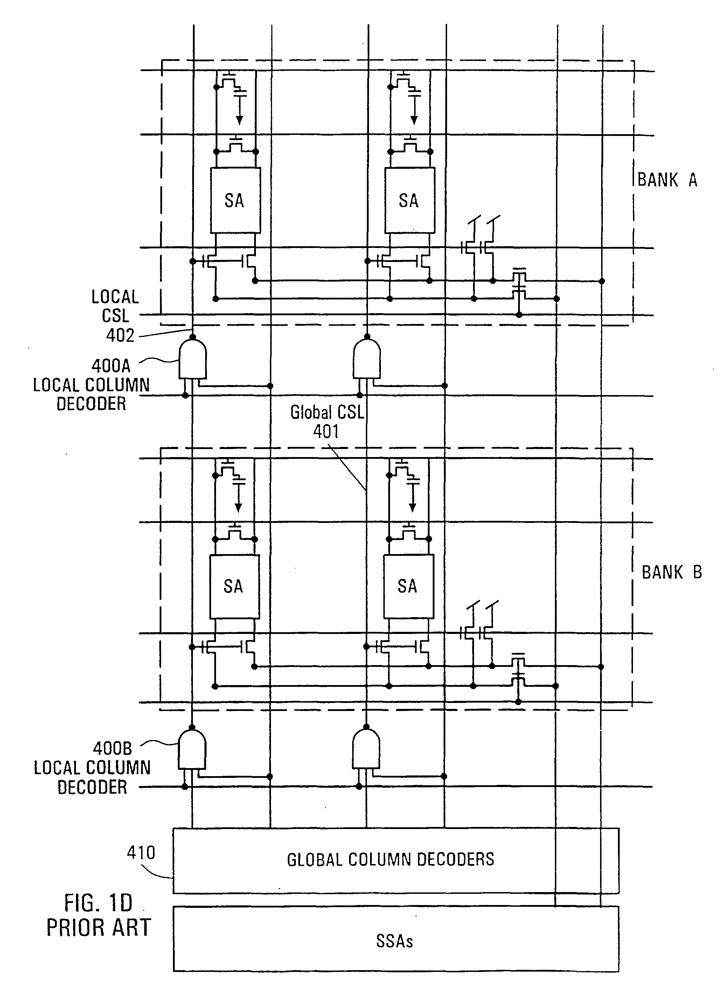

A third solution to the aforementioned problem pertaining the MDQ architecture. and which is commonly referred to as a "merged bank architecture" (MBA), is illustrated in FIG. 1d. Rather than using full column decoders 410 for each of the banks A and B, partial local column decoders 400A and 400B are added instead. Partial local column decoders 400A are driven by global column decoders 410. Since partial column decoders (400A and 400B) are smaller than full column decoders, the area penalty can be substantially reduced. However, this approach requires extra interconnecting wires (i.e., twice as many) for global CSL 401 and local CSL 402, which are difficult to accommodate within the limited space available. Details of this architecture may be found in an article published in the IEEE Journal of Solid-State Circuits, Vol. 31, No. 11, pp. 1635-1644, entitled: "A 32-Bank 1Gb Self-Strobing Synchronous DRAM with 1GByte/s Bandwidth", by Jei-Hwan Yoo, et al.

Other solutions are shown in EP0401792 and US5592434 of which the latter one differs from this invention as defined in claim 1 and claim 4 in that it decouples at least one bitline pair in a non-selected bank from at least one pair of first data lines in said non-selected bank.

Accordingly, it is an object of the invention to build a DRAM having at least two banks within a unit forming the DRAM with a minimum amount of circuitry.

It is another object of the invention to design a DRAM by configuring a plurality of banks within each unit forming the DRAM.

It is another object of the invention to have a DRAM provided with at least two banks utilise a Master DQ architecture. while minimising the amount of circuitry to achieve such a design.

It is still another object of the invention to protect a multi-bank DRAM having an Master DQ architecture from destroying data stored in a cell.

It is yet another object of the invention to have a multi-bank DRAM be provided with at least one global CSL lines and a plurality of bank CSLs.

It is a more particular object of the invention to have a multi-bank DRAM be provided with a CSL architecture, wherein bank CSL lines are shared by some of the banks but not by the others, and wherein the global CSL is shared by all the banks.

It is further another object of the invention to have the design of the multi-bank CSL oriented, MDQ architecture DRAM, with a minimum amount of interconnecting wires.

It is a still a further object of the invention to have a multi-bank DRAM be provided with a CSL architecture to be controlled by global column decoders and by bank column decoders.

It is a yet a further object of the invention to have a multi-bank DRAM be controlled by a single column decoder block.

Accordingly, it is an object of the invention to provide a method of structuring a DRAM having at least two banks within a unit forming the DRAM with a minimum amount of circuitry.

It is another object of the invention to provide a method of designing a DRAM by configuring a plurality of banks within each unit forming the DRAM.

It is another object of the invention to provide a method of organising a DRAM having at least two banks such that it utilises a Master DQ architecture, while minimising the amount of circuitry to achieve such a design.

It is still another object of the invention to protect a multi-bank DRAM having an Master DQ architecture from destroying data stored in a cell.

It is yet another object of the invention to have a multi-bank DRAM be provided with at least one global CSL lines and a plurality of bank CSLs.

It is a more particular object of the invention to have a multi-bank DRAM be provided with a CSL architecture. wherein bank CSL lines are shared by some of the banks but not by the others, and wherein the global CSL is shared by all the banks.

It is further another object of the invention to have the design of the multi-bank CSL oriented. MDQ architecture DRAM, with a minimum amount of interconnecting wires.

It is a still a further object of the invention to have a multi-bank DRAM be provided with a CSL architecture to be controlled by global column decoders and by bank column decoders.

It is a yet a further object of the invention to have a multi-bank DRAM be controlled by a single column decoder block.

The shortcomings of the prior art are overcome and additional advantages are realised through the provision of a multi-bank DRAM architecture having at least one global CSL lines and a plurality of bank CSLs.

The DRAM is provided with a CSL architecture, in which the bank CSL lines are shared by some of the banks but not by others, and wherein the global CSL is shared by all the banks. The CSL architecture of the DRAM is controlled by global column decoders and by bank column decoders.

In another aspect of the invention, the design of the multi-bank CSL oriented, MDQ architecture DRAM, is controlled by a single column decoder block, consisting of global column decoders and local column decoders.

Accordingly, the invention provides a dynamic random access memory including at least two banks, each of said banks including memory cells arranged in rows and columns, said memory cells storing data provided by at least one bit line and by at least one data line, the dynamic random access memory comprising: first decoding means for selecting one of at least two bank column select lines so as to select a memory bank; second decoding means for selecting at least one global column select line; first switching means controlled by said at least two bank column select lines, for coupling at least one bitline pair in said selected bank to at least one pair of first data lines in said selected bank whilst decoupling at least one bitline pair in a non selected bank from at least one pair of first data lines in said non-selected bank; and second switching means connected to the first switching means and controlled by said at least one global column select line for coupling said at least one pair of first data lines to at least one pair of second data lines, thereby enabling data to be written into or read out of said at least one bitline pair to said at least one pair of second data lines for said selected bank.

In a second embodiment, a DRAM consists of at least two banks. Each of the two banks includes a plurality of blocks.

Each of the blocks is formed by memory cells arranged in rows and columns. The memory cells store data provided by at least one bit line and at least one data line. The DRAM includes: a first switch for selecting one of the at least two banks; a second switch connected to the first switch for selecting one of the columns; and a third switch connected to the second switch for selecting one of the blocks in each of the at least two banks. wherein the first, second. and third switches couple one of the bit lines to one of the data lines, enabling data to be written into or read out of memory cells common to the selected bank and to the selected column.

In a third embodiment, a DRAM consists of at least two banks. Each of the banks is formed by memory cells which are arranged in rows and columns. The memory cells store data provided by at least one bit line and at least one data line. The DRAM includes: a first switch for selecting one of the columns within the first bank of the at least two banks and for coupling one of the bit lines within the first bank to one of the data lines; and a second switch for selecting one of the columns within the second bank of at least two banks and for coupling one of the bit lines within the second bank to one of the data lines, wherein the first and the second switches are controlled by two independent column select lines, and wherein the first of the two column select lines spans over both of the banks, and the second of the two column select lines spans over one of the at least two banks.

The invention further provides a method of structuring a dynamic random access memory including at least two banks, each of said banks including memory cells arranged in rows and columns, said memory cells storing data provided by at least one bit line and by at least one data line, the method comprising: selecting one of at least two bank column select lines so as to select a memory bank; selecting at least one global column select line; coupling at least one bitline pair in said selected bank to at least one pair of first data lines in said selected bank whilst decoupling at least one bitline pair in a non selected bank from at least one pair of first data lines in said non-selected bank; and coupling said at least one pair of first data lines to at least one pair of second data lines, thereby enabling data to be written into or read out of said at least one bitline pair to said at least one pair of second data lines for said selected bank.

There is provided a method of structuring a dynamic random access memory having at least two banks. Each of the two banks contains a plurality of blocks. Each of the blocks is formed by memory cells arranged in rows and columns. The memory cells store data which is provided by at least one bit line and at least one data line. The method includes the steps of: selecting one of the at least two banks; selecting one of the columns; and selecting one of the blocks in each the at least two banks, coupling one of the bit lines to one of the data lines, thereby enabling data to be written into or read out of memory cells common to the selected bank and to the selected column.

For example there is provided a method of structuring a dynamic random access memory having at least two banks. Each of the banks is formed by memory cells arranged in rows and columns.

The memory cells store data provided by at least one bit line and at least one data line. The method includes the steps of: selecting one of the columns within the first bank of at least two banks and coupling one of the bit lines within the first bank to one of the data lines; and selecting one of the columns within the second bank of at least two banks and coupling one of the bit lines within the second bank to one of the data lines. The selections are respectively controlled by two independent column select lines. The first of the two column select lines spans over both of the banks and the second of the two column select lines spans over one of the at least two banks.

The subject matter which is regarded as the invention is particularly pointed out and distinctly claimed in the claims at the conclusion of the specification. The foregoing and other objects, features and advantages of the invention will be apparent from the following detailed description taken in conjunction with the accompanying drawings in which:

FIG. 1a is a schematic representation of a prior art single bank 256Mb DRAM consisting of sixteen 16Mb units sectioned into sixteen 1Mb segments in the column direction, with its corresponding bitline pairs:

FIG. 1b is a detailed schematic diagram of a prior art CSL architecture for a single bank DRAM, showing two out of sixteen 64Kb arrays representing two blocks A and B:

FIG. 1c shows a prior art CSL architecture having two independent full column decoders for a multi-bank DRAM, respectively controlling banks A and B;

FIG. 1d shows a schematic diagram of a prior art, merged bank architecture for an (MBA) DRAM chip;

FIG. 2 is a schematic diagram of a Hierarchical CSL architecture applicable to four banks within a 16Mb unit, wherein the bank CSLs are allocated vertically, in accordance with a first embodiment of the present invention;

FIG. 3 is a schematic diagram of a Hierarchial CSL architecture applicable to four banks within a 16Mb unit, wherein the bank CSLs are allocated horizontally, in accordance with a second embodiment of the present invention; and

FIG. 4 shows a schematic diagram of a CSL architecture applicable to four banks within a 16Mb unit, wherein no global CSL is required altogether and all the bank CSLs within each corresponding bank act independently of each other, in accordance with a third embodiment of the present invention.

It is known in the an that data could be destroyed in a cell if a column switch transistor were to open while a signal is in the process of being generated. This is a fundamental problem in multi-bank DRAM designs with Master-DQ architecture, wherein CSLs are shared between several banks. This invention overcomes the problem with global CSLs (GCSL) and bank CSLs (BCSL), providing a promising architecture for giga-bit scale DRAMs and embedded DRAM macros.

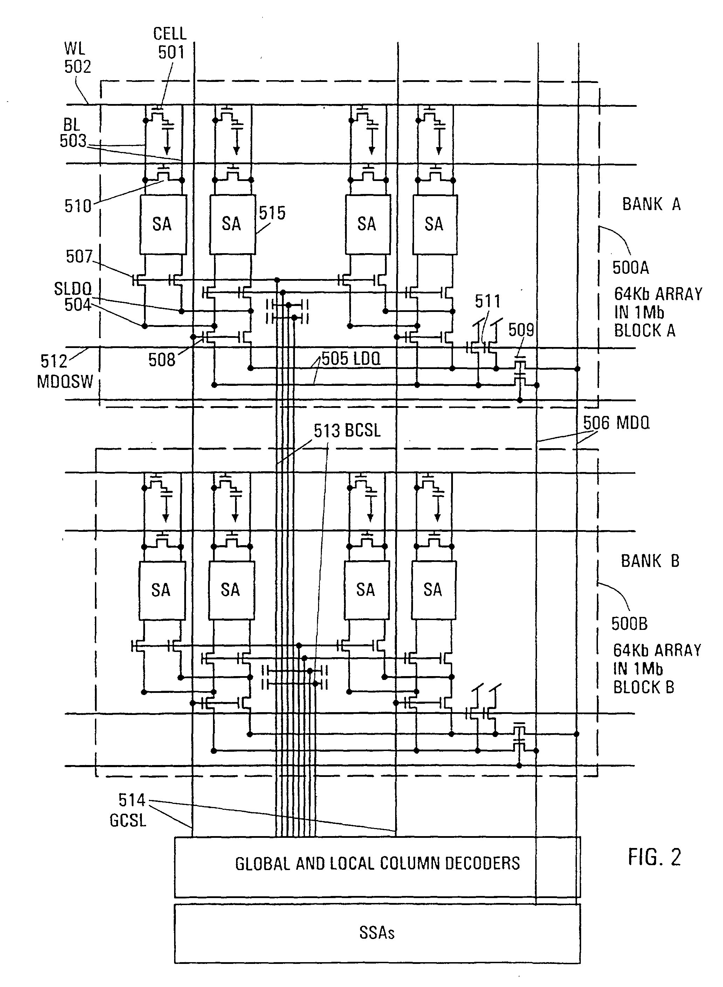

Referring to FIG. 2, there is shown a CSL architecture, according to the invention, which is illustrated to a memory having four banks within a 16Mb unit. and which, only two are shown therein for simplicity purposes. Instead of using 32 CSLs in one segment 102 (as was shown in Fig. 1a), eight global column select lines (GCSL) 514 and four groups of four bank column select lines (BCSL) 513 (for a total of 16 BCSLs) are assigned to each segment. A first pair of NMOS (or, alternatively PMOS) transistors 507 couples each BL pair 503 to sub-local DQ 504 (or SLDQ 504) to form a first stage column switch.

A second pair of NMOS transistors 508 couples SLDQ 504 to local DQ 505 (or LDQ 505) to form a second stage column switch. The first pair of NMOS transistors 507 is controlled by the corresponding four sets of four bank CSLs 513 (or BCSL 513, for a total of 16. The third pair of NMOS transistors 509 couples LDQ 505 to Master DQ 506 (or MDQ 506) to form the MDQ switch. BCSLs 513 are shared within the same bank, although not shared with other banks). Likewise, the second pair of NMOS transistors 508 is controlled by the corresponding 1 out of 8 GCSLs 514. The GCSLs are shared by all banks. In any given bank, BCSLs 513 can be independently controlled, disabling the column switch even when GCSL is enabled for a column operation of a different bank. The total number of GCSLs and BCSLs equals:

8 GCSLs + 16 BCSLs/segment,

substantially less than that required by a conventional MDQ architecture (i.e., 32 CSLs/segment). This allows GCSLs 514 and BCSLs 513 to be laid out over the array in the same manner as in a conventional MDQ architecture, while relaxing the pitch by 25%.

The detailed operation of the arrangement shown in FIG. 2 will now be discussed.

It is assumed that initially, bank A is in a standby mode, whereas bank B is in a column access mode. While bank A is in stand-by mode, all BLs 503 and LDQs 505 (in bank A) are pre-charged to ½ the value of Vdd.

When bank A is enabled (i.e., entering the signal development mode), BL equalizers 510 and MDQ equalizers 511 are disabled first in a conventional manner. MDQ transistors 509 are opened, forcing the LDQ follow the MDQ voltages. Note that the MDQs and the GCSLs are now used by bank B when B is in the column access mode. WL 202 then rises to read data from cell 501.

Upon completion of the bank signal development mode, (i.e., after that data from the cell to the bitline 503 has been transferred), sense amplifiers (SA) 515 are activated. Until the column access mode is initiated for bank A. the BCSLs 513 of bank A remain at a low, thereby avoiding data destruction from incurring, even if GCSL 514 is activated for bank B while it is in the column access mode.

When the column access mode is enabled for bank A. 1 out of 4 BCSLs 513 coupled to bank A is enabled. Note that MDQs 506 and GCSLs 514 are now used for bank A, allowing amplified cell data 501 in bank A to be transferred through sub-LDQ (SLDQ) 504. LDQ 505, and MDQ 506 when in a read mode, or vise-versa when in a write mode. While bank A is in a column access mode, BCSLs 513 in bank B remain at a low.

This architecture allows GCSLs 513 to be shared between the various banks, requiring only one column decoder/16Mb unit. Column decoders which generate GCSLs and BCSLs are, preferably, laid out at the bottom of the unit to minimise the silicon area penalty. The number of NMOSs 508 connected to the LDQ is ¼ that of a conventional MDQ architecture, thereby substantially reducing the LDQ capacitance. Indeed, the SLDQ 504 capacitance is only about 10fF, which can easily be driven by one sense amplifier (SA), overcoming any potential data destruction due to charge sharing between the BLs and SLDQ.

Optionally, MDQ switch 509 can be eliminated by directly coupling LDQ 505 to MDQ 506, provided the BCSLs 513 are not shared with other 1Mb blocks 500 within the same bank. In this instance, BCSLs 513 are fully independently controlled for the corresponding 1Mb blocks 500, all of which are controlled by the column decoder, preferably located at the bottom of the unit.

This first embodiment of the invention may have the following features:

a) first switching means maybe controlled by a bank column select line (513)

b) bank column select line (513) maybe generated by a decoding means which decodes an address in one of said at least two banks (A,B).;

c) the decoding means, which decodes an address in one of said at least two banks (A.B) may, also decode another address which is unrelated to said bank address:

d) the bank column select line (513) maybe arranged vertically over at least one of said two banks (A,B) along said rows;

e) the bank column select line (513) maybe arranged horizontally over at least one of said two banks (A,B) along said columns;

f) the second switching means (508) maybe controlled by a global column select line (514);

g) the global column select line (514) maybe generated by a decoding means which decodes an address in one of said columns;

h) the global column select line (514) maybe arranged vertically over at least one of said two banks (A,B) along said rows;

i) the global column select line (514) maybe arranged horizontally over at least one of said two banks (A,B) along said columns;

j) the first and second switching means (507,508) maybe selected from the group consisting of an NMOS device and a PMOS device;

k) the said NMOS or PMOS device forming said first switching means (507), may have a gate which is coupled to said bank column select line (513);

l) the said NMOS or PMOS device forming said second switching means (508), may have a gate which is coupled to said global column select line (513).

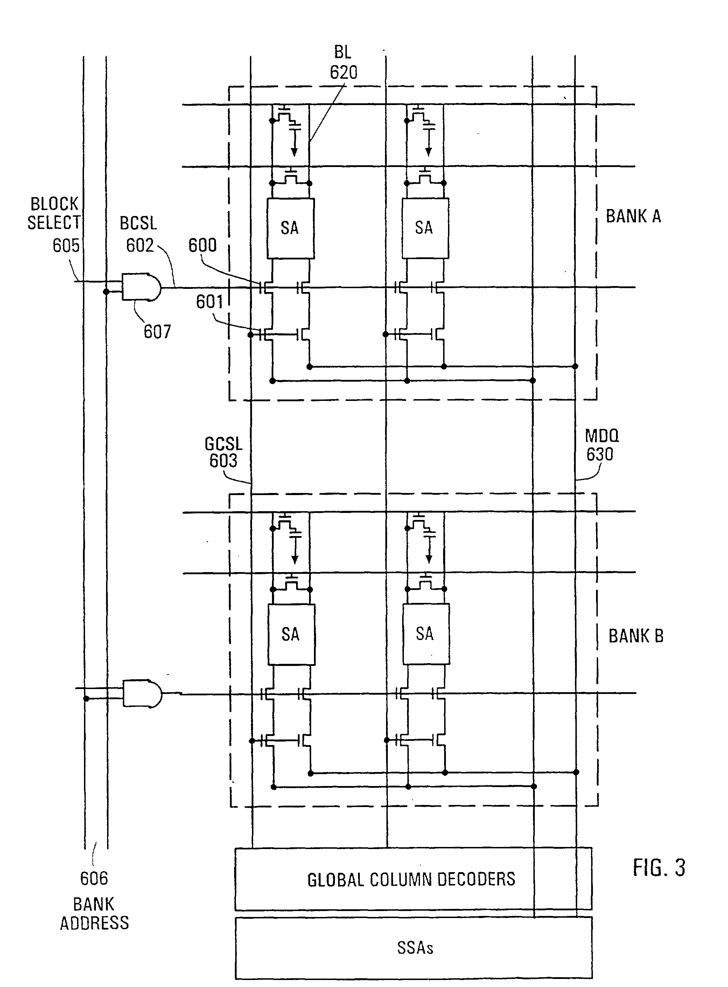

A second embodiment of the invention.is illustrated in FIG. 3. Instead of allocating the BCSLs 402 vertically as shown in FIG. 2. BCSLs 602 are distributed horizontally. Two series of NMOSs transistors 600 and 601 are used to read/write data from BLs 620 cell to MDQs 630, in an arrangement similar to the one described in the previous embodiment, although SLDQs and LDQs may be dispensed of altogether. NMOSs 601 are controlled by the globally shared CSL (GCSL), exactly as in the previous case.

The decoded signals in the BCSLs are determined by bank address 606 and block select signal 605. BCSL is only activated when both. the block and the bank are selected. The block select is not enabled until the signal development phase is complete. disabling NMOS 600. This allows bank B to remain in column access mode. while bank A remains in signal development mode.

Optionally, the decoded signal can be used for the bank select signal, which decodes the column address. bank address, and block select. The drawback of this embodiment compared to the previous one is that the capacitance loading of the BCSL is substantially larger, resulting in a slower operation.

This second embodiment may also have the features listed at a) to l) above in relation to the first embodiment. In addition the second embodiment may also have the following features:

m) the third switching means (509) maybe controlled by a block select line (605);

n) the block select line (605) maybe generated by a decoder which decodes an address in one of said blocks (A,B) within each of said at least two banks;

o) the decoder, which decodes an address in one of said blocks, may also decode another address which is unrelated to said block address.

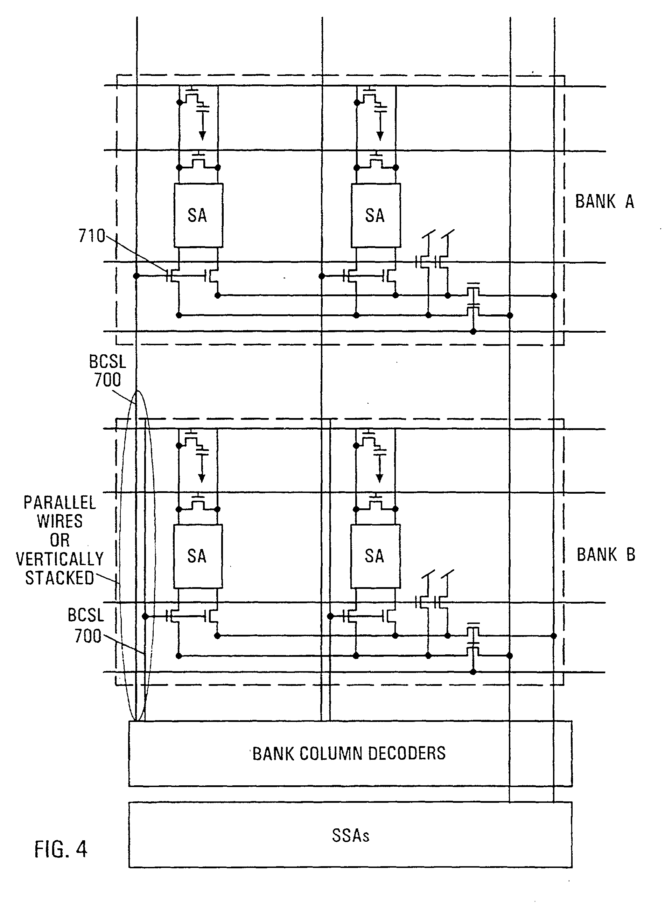

FIG. 4 shows a third embodiment of the invention. In this embodiment, there is no need to have a GCSL. In each bank, all BCSLs 700 are independent of the BCSL located in another bank. Unlike the prior art architecture shown in FIG. 1b, all column decoders are, preferably, laid out at the bottom of the unit.

NMOSs 710 are controlled by the bank independent CSL, allowing bank A to be in the signal development mode, while the bank B is in the column access mode. This embodiment, however requires substantially more interconnecting wires to accommodate the BCSLs independently. Practitioners of the art will fully realize that additional metal could be used to bypass the BCSLs in the upper array, thereby making it possible to contain the layout within the given space.

This third embodiment may have the following features:

p) the first of said two independent column select line maybe generated by a first decoder which decodes an address in one of said at least two banks (A,B), and the second of said two independent column select line maybe generated by a second decoder which decodes an address in the second of said at least two banks;

q) the said two independent column select lines may be positioned parallel to said columns over said at least two banks (A,B);

r) the two independent column select lines are positioned perpendicular to said columns over said at least two banks (A,B);

s) the dynamic random access memory of claim 24, wherein said first and second decoders are located next to each other.

## Claims

1. A dynamic random access memory including at least two banks, each of said banks including memory cells arranged in rows and columns, said memory cells storing data provided by at least one bit line (503) and by at least one data line (505, 506), the dynamic random access memory comprising:

first decoding means for selecting one of at least two bank column select lines (BCSL 513) so as to select a memory bank;

second decoding means for selecting at least one global column select line (GCSL 14);

first switching means (507) controlled by said at least two bank column select lines (BCSL 513), for coupling at least one bitline pair (BL 503) in said selected bank to at least one pair of first data lines (SLDQ 504) in said selected bank whilst decoupling at least one bitline pair in a non selected bank from at least one pair of first data lines in said non-selected bank; and

second switching means (508) connected to the first switching means (507) and controlled by said at least one global column select line (GCSL 514) for coupling said at least one pair of first data lines (SLDQ 504) to at least one pair of second data lines (MDQ 506), thereby enabling data to be written into or read out of said at least one bitline pair (BL 503) to said at least one pair of second data lines (MDQ 506) for said selected bank.

2. The dynamic random access memory of claim 1 including a plurality of blocks, each of said blocks including memory cells, said memory further comprising:

third decoding means for selecting a master data selection switch line (MDQSW 512); and

third switching means (509) controlled by said at least master data selection switch line (MDQSW 512) for coupling said at least one pair of second data lines (LDQ 505) to at least one pair of third data lines (MDQ 506), thereby enabling data to be written into or read out of said at least one bitline pair (BL 503) to said at least one of pair of third data lines (MDQ 506);

third switching means (509) connected to said second switching means for selecting one of said blocks (500A,500B) in each of said at least two banks, wherein said first (507), second (508), and third (509) switching means couple one of said bit lines (503) to one of said data lines (505,506), enabling data to be written into or read out of memory cells (501) common to said selected bank and to said selected column.

3. A dynamic random access memory as claimed in claim 1 or 2 further comprising:

row selection means responsive to a row address for selecting a row of said memory cells, wherein said bit lines read out or write in data in said selected row memory cells; and

a column selection means for selecting column memory cells, said means being responsive to a column address, said column selection means comprising the first switching means for decoding a first address of at least one of said banks and the second switching means for decoding a second address in said at least one of said banks.

4. A method of structuring a dynamic random access memory including at least two banks, each of said banks including memory cells arranged in rows and columns, said memory cells storing data provided by at least one bit line and by at least one data line, the method comprising:

selecting one of at least two bank column select lines (BCSL 513) so as to select a memory bank;

selecting at least one global column select line (GCSL 14);

coupling at least one pair of first data lines (SLDQ 504) to at least one pair of second data lines (MDQ 506), thereby enabling data to be written into or read out of at least one bitline pair (BL 503) in said selected bank to said at least one pair of second data lines (MDQ 506) for said selected bank; and

**characterised by** coupling said at least one bitline pair (BL 503) in said selected bank to said at least one pair of first data lines (SLDQ 504) in said selected bank whilst decoupling, at least one bitline pair in a non selected bank from at least one pair of first data lines in said non-selected bank.

5. The method of claim 4 including a plurality of blocks, each of said blocks including memory cells, said method further comprising:

selecting one of said blocks (500A,500B) in each of said at least two banks, wherein selection via said first, second and third selecting steps couple one of said bit lines (503) to one of said data lines (505,506), enabling data to be written into or read out of memory cells (501) common to said selected bank and to said selected column.

**Patentansprüche**

1. Dynamischer Speicher mit wahlfreiem Zugriff mit mindestens zwei Bänken, wobei jede Bank in Zeilen und Spalten angeordnete Speicherzellen enthält und jede Speicherzelle durch mindestens eine Bitleitung (503) und mindestens eine Datenleitung (505, 506) bereitgestellte Daten speichert und der dynamische Speicher mit wahlfreiem Zugriff Folgendes umfasst:

ein erstes Decodiermittel zum Auswählen einer der mindestens zwei Bankspalten-Auswahlleitungen (BCSL 513), um damit eine Speicherbank auszuwählen;

ein zweites Decodiermittel zum Auswählen mindestens einer globalen Spalten-Auswahlleitung (BCSL 14);

ein erstes durch die mindestens zwei Bankspalten- Auswahlleitungen (BCSL 513) angesteuertes Schaltmittel (507) zum Verbinden mindestens eines Bitleitungspaares (BL 503) in der ausgewählten Bank mit mindestens einem Paar erster Datenleitungen (SLDQ 504) in der ausgewählten Bank und zum gleichzeitigen Trennen mindestens eines Bitleitungspaares in einer nicht ausgewählten Bank von mindestens einem Paar erster Datenleitungen in dieser nicht ausgewählten Bank; und

ein zweites mit dem ersten Schaltmittel (507) verbundenes zweites Schaltmittel (508), das durch die mindestens eine globale Spalten-Auswahlleitung (GCSL 514) angesteuert wird, zum Verbinden des mindestens einen Paars erster Datenleitungen (SLDQ 504) mit mindestens einem Paar zweiter Datenleitungen (MDQ 506), damit Daten in das mindestens eine Paar zweiter Datenleitungen (MDQ 506) dieser ausgewählten Bank geschrieben oder aus dem mindestens einen Bitleitungspaar (BL 503) in das mindestens eine Paar zweiter Datenleitungen (MDQ 506) gelesen werden können.

2. Dynamischer Speicher mit wahlfreiem Zugriff nach Anspruch 1, der eine Vielzahl von Blöcken enthält, welche wiederum Speicherzellen enthalten und wobei der Speicher ferner Folgendes umfasst:

ein drittes Decodierungsmittel zum Auswählen einer Datenauswahl-Hauptschaltleitung (MDQSW 512); und

ein drittes durch diese mindestens eine Datenauswahl- Hauptschaltleitung (MDQSW 512) angesteuertes Schaltmittel zum Verbinden mindestens eines Paars zweiter Datenleitungen (LDQ 5050) mit mindestens einem Paar dritter Datenleitungen (MDQ 506), damit Daten in das mindestens eine Paar dritter Datenleitungen (MDQ 506) geschrieben oder aus dem mindestens einen Bitleitungspaar (BL 503) in das mindestens eine Paar dritter Datenleitungen (MDQ 506) gelesen werden können;

ein drittes mit dem zweiten Schaltmittel verbundenes Schaltmittel (509) zum Auswählen eines der Blöcke (500A, 500B) in jeder der mindestens zwei Bänke, wobei das erste (507), das zweite (508) und das dritte (509) Schaltmittel eine der Bitleitungen (503) mit einer der Datenleitungen (505, 506) verbinden, damit Daten in die Speicherzellen geschrieben oder aus ihnen gelesen werden können, welche zu der ausgewählten Bank und der ausgewählten Spalte gehören.

3. Dynamischer Speicher mit wahlfreiem Zugriff nach Anspruch 1 oder 2, der ferner Folgendes umfasst:

ein Zeilenauswahlmittel, das auf eine Zeilenadresse zur Auswahl einer Zeile der Speicherzellen reagiert, wobei die Bitleitungen Daten in die Speicherzellen der ausgewählten Zeile schreiben oder aus ihnen lesen; und

ein Spaltenauswahlmittel zum Auswählen der Speicherzellen einer Spalte, wobei das Mittel auf eine Spaltenadresse reagiert und das Spaltenauswahlmittel das erste Schaltmittel zum Decodieren einer ersten Adresse mindestens einer der Bänke und das zweite Schaltmittel zum Decodieren einer zweiten Adresse mindestens einer der Bänke umfasst.

4. Verfahren zum Strukturieren eines dynamischen Speichers mit wahlfreiem Zugriff mit mindestens zwei Bänken, wobei jede der Bänke in Zeilen und Spalten angeordnete Speicherzellen beinhaltet und in den Speicherzellen Daten gespeichert werden, die durch mindestens eine Bitleitung und mindestens eine Datenleitung bereitgestellt werden, und wobei das Verfahren Folgendes umfasst:

Auswählen einer der mindestens zwei Bankspalten- Auswahlleitungen (BCSL 513), um eine Speicherbank auszuwählen;

Auswählen mindestens einer globalen Spalten-Auswahlleitung (GCSL 14);

das Verbinden mindestens eines Paars erster Datenleitungen (SLDQ 504) mit mindestens einem Paar zweiter Datenleitungen (MDQ 506), damit Daten des mindestens einen Bitleitungspaares (BL 503) der gewählten Bank in das mindestens eine Paar von zweiten Bitleitungen (MDQ 506) der gewählten Bank geschrieben oder aus ihnen gelesen werden kann; und

**gekennzeichnet durch**
das Verbinden des mindestens einen Bitleitungspaars (BL 503) in der ausgewählten Bank mit dem mindestens einen Paar erster Datenleitungen (SLDQ 504) in der ausgewählten Bank und das gleichzeitige Trennen des mindestens einen Bitleitungspaars in einer nicht ausgewählten Bank von dem mindestens einen Paar erster Datenleitungen in der nicht ausgewählten Bank.

5. Verfahren nach Anspruch 4, welches eine Vielzahl von Blöcken beinhaltet, wobei jeder Block Speicherzellen enthält und das Verfahren ferner Folgendes umfasst:

Auswählen eines der Blöcke (500A, 500B) in jeder der mindestens zwei Bänken, wobei durch die Auswahl mittels des ersten, zweiten und dritten Auswahlschritts eine der Bitleitungen (503) mit einer der Datenleitungen (505, 506) verbunden wird und Daten in Speicherzellen (501) geschrieben oder aus ihnen gelesen werden können, die zu der ausgewählten Bank und der ausgewählten Spalte gehören.

## Revendications

1. Mémoire vive dynamique comprenant au moins deux groupes, chacun desdits groupes comprenant des cellules de mémoire disposées en rangées et colonnes, lesdites cellules de mémoire mémorisant des données fournies par au moins une ligne de bit (503) et par au moins une ligne de données (505, 506), la mémoire vive dynamique comprenant :

   un premier moyen de décodage destiné à sélectionner l'une d'au moins deux lignes de sélection de colonne de groupe (BCSL 513) de façon à sélectionner un groupe de mémoire,

   un second moyen de décodage destiné à sélectionner au moins une ligne de sélection de colonne globale (GCSL 14),

   un premier moyen de commutation (507) commandé par lesdites au moins deux lignes de sélection de colonne de groupe (BCSL 513) afin de coupler au moins une paire de lignes de bits (BL 503) dans ledit groupe sélectionné à au moins une paire de premières lignes de données (SLDQ 504) dans ledit groupe sélectionné tout en découplant au moins une paire de lignes de bits dans un groupe non-sélectionné d'au moins une paire de premières lignes de données dans ledit groupe non-sélectionné, et

   un second moyen de commutation (508) relié au premier moyen de commutation (507) et commandé par ladite au moins une ligne de sélection de colonne globale (GCSL 514) destiné au couplage de ladite au moins une paire de premières lignes de données (SLDQ 504) à au moins une paire de secondes lignes de données (MDQ 506), en permettant ainsi que des données soient écrites dans ladite au moins une paire de lignes de bits (BL 503) ou lues dans celle-ci pour ladite au moins une paire de secondes lignes de données (MDQ 506) pour ledit groupe sélectionné.

2. Mémoire vive dynamique selon la revendication 1, comprenant une pluralité de blocs, chacun desdits blocs comprenant des cellules de mémoire, ladite mémoire comprenant en outre :

   un troisième moyen de décodage destiné à sélectionner une ligne de commutateur de sélection de données maître (MDQSW 512), et

   un troisième moyen de commutation (509) commandé par ladite au moins une ligne de commutateur de sélection de données maître (MDQSW 512) destiné au couplage de ladite au moins une paire de secondes lignes de données (LDQ 505) à au moins une paire de troisièmes lignes de données (MDQ 506), en permettant ainsi que des données soient écrites dans ladite au moins une paire de lignes de bits (BL 503) et lues à partir de celle-ci vers ladite au moins une paire de troisièmes lignes de données (MDQ 506),

   un troisième moyen de commutation (509) relié audit second moyen de commutation afin de sélectionner l'un desdits blocs (500A, 500B) dans chacun desdits au moins deux groupes, où ledit premier (507), second (508) et troisième (509) moyen de commutation couplent l'une desdites lignes de bits (503) à l'une desdites lignes de données (505, 506) en permettant que des données soient écrites dans des cellules de mémoire (501) communes audit groupe sélectionné et à ladite colonne sélectionnée, ou lues à partir de celles-ci.

3. Mémoire vive dynamique selon la revendication 1 ou 2, comprenant en outre :

   un moyen de sélection de rangées répondant à une adresse de rangée afin de sélectionner une rangée desdites cellules de mémoire, où lesdites lignes de bits lisent en sortie ou écrivent en entrée des données dans lesdites cellules de mémoire de la rangée sélectionnée, et

   un moyen de sélection de colonne destiné à sélectionner des cellules de mémoire d'une colonne, ledit moyen répondant à une adresse de colonne, ledit moyen de sélection de colonne comprenant le premier moyen de commutation destiné à décoder une première adresse d'au moins l'un desdits groupes et le second moyen de commutation étant destiné à décoder une seconde adresse dans ledit au moins l'un desdits groupes.

4. Procédé de structuration d'une mémoire vive dynamique comprenant au moins deux groupes, chacun desdits groupes comprenant des cellules de mémoire disposées en rangées et en colonnes, lesdites cellules de mémoire mémorisant des données fournies par au moins une ligne de bit et par au moins une ligne de données, le procédé comprenant :

la sélection d'au moins deux lignes de sélection de colonne de groupe (BCSL 513) de façon à sélectionner un groupe de mémoire,

la sélection d'au moins une ligne de sélection de colonne globale (GCSL 514),

le couplage d'au moins une paire de premières lignes de données (SLDQ 504) à au moins une paire de secondes lignes de données (MDQ 506) en permettant ainsi que des données soient écrites dans au moins une paire de lignes de bits (BL 503) dudit groupe sélectionné ou lues à partir de celle-ci vers ladite au moins une paire de secondes lignes de données (MDQ 506) pour ledit groupe sélectionné, et

**caractérisé par** le couplage de ladite au moins une paire de lignes de bits (BL 503) dans ledit groupe sélectionné avec ladite au moins une paire de premières lignes de données (SLDQ 504) dans ledit groupe sélectionné tout en découplant au moins une paire de lignes de bits dans un groupe non-sélectionné d'au moins une paire de premières lignes de données dans ledit groupe non-sélectionné.

5.  Procédé selon la revendication 4, comprenant une pluralité de blocs, chacun desdits blocs comprenant des cellules de mémoire, ledit procédé comprenant en outre :

la sélection de l'un desdits blocs (500A, 500B) dans chacun desdits au moins deux groupes, où une sélection par l'intermédiaire desdites première, seconde et troisième étapes de sélection couple l'une desdites lignes de bits (503) à l'une desdites lignes de données (505, 506) en permettant que des données soient écrites dans des cellules de mémoire (501) communes audit groupe sélectionné et auxdites colonnes sélectionnées, ou soient lues à partir de celles-ci.

CSL
107

64Kb ARRAY
108

1Mb BLOCK
101A

103 WL

105 LDQ

108

104
BL

106 MDQ

1Mb BLOCK
101

RDECs

1Mb SEGMENT
102

1Mb BLOCK
101B

CDECs          109

SSAs           110

CHIP
10

16Mb UNIT
100

FIG. 1A
PRIOR ART

CELL
201

WL
202

BL
203

207

SA 204

LDQEQ
209

LDQ
211

208

206

205

MDQSW
210

CSL
213

SA

SA

SA

CDECs

SSAs

64Kb ARRAY
200A IN 1Mb
BLOCK A
(SIGNAL
DEVELOPMENT)

MDQ
212

64Kb ARRAY
200B IN 1Mb
BLOCK B
(COLUMN
ACCESS MODE)

FIG. 1B
PRIOR ART

FIG. 1C
PRIOR ART

BANK A

LOCAL
CSL
402

400A
LOCAL COLUMN
DECODER

Global CSL
401

BANK B

400B
LOCAL COLUMN
DECODER

410

GLOBAL COLUMN DECODERS

FIG. 1D
PRIOR ART

SSAs

FIG. 2

FIG. 3

BANK A

710

BCSL
700

PARALLEL
WIRES
OR
VERTICALLY
STACKED

BANK B

BCSL
700

BANK COLUMN DECODERS

SSAs

FIG. 4